# EUROPEAN PATENT APPLICATION

(11) **EP 1 157 853 A2**
(43) Date of publication of application: **28.11.2001**
(21) Application number: 01000152.7
(22) Date of filing: 18.05.2001
(51) Int. Cl.: B41N 3/03

(54) **Process for roughening support material for printing plates**

(30) Priority: 24.05.2000 DE 10025632
(71) Applicant: AGFA-GEVAERT N.V., 2640 Mortsel (BE)
(72) Inventor: Joerg, Klaus, 55218, Ingelheim (DE); Pliefke, Engelbert, 65187, Wiesbaden (DE); Brenk, Michael, 65199, Wiesbaden (DE)

(57) **Abstract**

A support material made from aluminium or an aluminium alloy for printing plates has a prestamped surface. The prior stamping comprises hemispherical indentations with a diameter of from 2 to 50 µm and a mean diameter of 20 to 30 µm. This support material is electrochemically roughened in an electrolyte which is selected from the group consisting of hydrochloric acid, nitric acid, sulphuric acid and chloride or nitrate ions of an aluminium salt. The current density of the alternating current is 30 to 45 A/dm². The surface roughness R_{A} after roughening is uniform, covers the entire area and lies in the range from 1.0 to 1.5 µm.

## Description

The invention relates to a process for roughening support material of printing plates made from prestamped aluminium or prestamped aluminium alloys, in one surface of which hemispherical indentations with a diameter of from 2 to 50 µm are stamped.

In the printing plate field, aluminium or one of its alloys has become an accepted layer support material. The layer supports are generally pretreated, for example by a mechanical, chemical and/or electrochemical roughening, a chemical or electrochemical (anodic) oxidation and, if appropriate, a treatment with hydrophilizing agents.

The roughening is carried out, inter alia, in order to improve the adhesion of the reproduction layer to the layer support and the water carrying in the printing forme which is formed from the printing plate by exposure and development. As a result of the exposure and development or the removal of the layer in the case of electrographically operating reproduction layers, the image areas which carry ink and the non-image areas which carry water during the subsequent printing are produced on the printing plate, with the result that the actual printing forme is formed. The water-carrying non-image areas are the support surface from which the reproduction layer has been removed.

The mechanical roughening can be carried out by wire brushes or wet brushing with a slurry of fine-grained material. Processes of this type are described in EP-A-0 292 801 and DE-A 33 05 067, as well as the documents cited therein.

An electrochemical roughening process is disclosed, inter alia, in EP B 0 422 682, in which the surface of an aluminium plate is continuously roughened by electrochemical means in an acidic electrolyte using an alternating current. The alternating current used to roughen the surface is partially connected in parallel via rectifier devices and is then used for the cathodic electrolysis of the aluminium plate in an aqueous, neutral salt solution.

DE-A 30 12 135 describes a process for producing a support for lithographic printing plates, in which the surface of the aluminium plate is mechanically roughened, approximately 5 to 20 g/m² of aluminium are chemically etched off the surface of the plate, and an electric current of alternating waveform is applied to the plate in an acidic aqueous solution in such a way that the amount of electricity produced with the plate as anode is greater than or equal to the amount of electricity produced with the plate as cathode. The electrolysis is carried out in such a manner that the current density, when the plate is the anode, is greater than or equal to approximately 20 amperes/dm². In this case, a ratio of the electricity produced with the plate as cathode to the electricity produced with the plate as anode of approximately 0.5: 1 to 1.0:1 is used.

EP-B 0 536 531 describes an electrochemical two-stage process, in which a first electrochemical roughening step takes place in an electrolyte which is selected from the group consisting of hydrochloric acid, nitric acid, sulphuric acid and additions of chloride or nitrate ions of an aluminium salt, and a second electrochemical roughening step follows the first roughening step and takes place in an electrolyte which is selected from the group consisting of hydrochloric acid, nitric acid, sulphuric acid and additions of chloride or nitrate ions of an aluminium salt. The concentrations of the additions selected from the group are identical or different in the second roughening step from those used in the first roughening step.

Consideration has long been given to accelerating, i.e. shortening, the roughening processes, by using a support material in which a structure has been prestamped as early as during rolling of the support material, which is generally carried out by the manufacturer, and the crystal grain boundaries have been disrupted in such a way that electrochemical roughening can take place with a lower consumption of energy than if the support material had not been prestamped. Prestamping of this nature on aluminium webs or strips is known. For example, DE-A 28 32 580 describes a process for producing base material for offset printing plates, in which a surface which has been roughened on one side is produced on an aluminium strip, two prerolled aluminium strips are placed on top of one another and are fully rolled together, with the result that a surface roughness is formed on the surfaces which are in contact with one another. After the rolling operation, the strips are separated from one another, and a stable oxide layer is formed on their roughened surfaces in particular as a result of ageing during storage. This process has the drawback that the surface structure is coarse for lithographic purposes and is difficult to control and, furthermore, has a clear directional orientation in the rolling direction, which is unfavourable for printing plates.

Prior roughening of this type is also described in WO 95/08408 for lithographic printing plates. In this case, irregular, pre-roughened structures are formed on the sides which are remote from the rollers, i.e. on the surfaces at which one aluminium web is resting on the other aluminium web.

The automotive industry uses aluminium sheets which are produced using what is known as "LASERTEX" process, in which a steel roller into which small cups are burnt by means of a laser are used as the stamping roller in the final rolling step. However, these structures are relatively coarse and are unsuitable for lithographic purposes. Furthermore, production of the aluminium sheets becomes expensive, since the small cups in stamping rollers of this type quickly become blurred by the soft aluminium and therefore the stamping rollers have to be replaced frequently.

Further processes for texturing stamping rollers which mechanically roughen the surfaces of metal strips or sheets are described in the document "Surface qualification in the sheet metal domain" published by the Technical University of Darmstadt. This document is available on the Internet at http://www.ptu.tu-darmstadt.de/forschung/tribologie/ shemet/kap5.htm.

It is an object of the invention to significantly reduce the outlay on energy for the mechanical and in particular electrochemical roughening and to increase productivity when producing the support material for printing plates.

According to the invention, this object is achieved with the aid of prestamped support material of the type described in the introduction in such a manner that
- the electrochemical roughening step proceeds by means of alternating current in an electrolyte which is selected from the group consisting of hydrochloric acid, nitric acid, sulphuric acid and chloride or nitrate ions of an aluminium salt, and in such a manner that
- roughening is carried out uniformly and in an area-covering manner, with a surface roughness R_{A} of from 1.0 to 1.5 µm.

In a refinement of the process, the roughening step is carried out in an electrolyte comprising hydrochloric acid and aluminium chloride, nitric acid and aluminium nitrate or sulphuric acid and aluminium sulphate, the surface roughness Rₐ of from 0.30 to 1.1 µm of the prestamped aluminium or the prestamped aluminium alloy being increased by 1.3 to 3.3 times. The increase is determined according to the ratio of surface roughness R_{A} after the electrochemical roughening to surface roughness Rₐ of the stamped aluminium.

The further configuration of the process will emerge from the features of Patent Claims 3 to 16.

As soon as the support material has been electrochemically roughened, an anodizing step takes place in an electrolyte which contains sulphuric acid, phosphoric acid, oxalic acid, amidosulphonic acid, sulphosuccinic acid, sulphosalicylic acid or mixtures of these acids. In this case, the anodic oxidation takes place using direct current, alternating current or direct current with superimposed alternating current, and layer weights of 1 to 3 g/m² of aluminium oxide are obtained.

A printing plate made from a support material which has been electrochemically roughened and oxidically anodized in the manner described above is produced in such a way that the support material is coated with a radiation-sensitive material, which is inherently known per se, of the following composition, where pbw = parts by weight and pbv = parts by volume:

| | |
|---|---|
| 6.6 pbw | of cresol/formaldehyde novolak with a softening range of 105 to 120°C, |
| 1.1 pbw | of the 4-(2-phenyl-2-propyl)-phenyl ester of 1,2-naphthoquinone-2-diazide-4-sulphonic acid, |
| 0.6 pbw | of 2,2'-bis(1,2-naphthoquinone-2-diazide-5-sulphonyloxy)-1,1'-dinaphthylmethane, |
| 0.24 pbw | of 1,2-naphthoquinone-2-diazide 4-sulphochloride, |
| 0.08 pbw | of Crystal Violet |
| 91.36 pbw | of a solvent mixture comprising 4 pbv ethylene glycol monomethyl ether, 5 pbv tetrahydrofuran and 1 pbv butyl acetate. |

According to the invention, this coated support material is dried at temperatures of up to 120°C.

Suitable light-sensitive reproduction layers are in principle all layers which, after the exposure, subsequent development and/or fixing, provide a printing surface from which it is possible to print and/or which reproduce a relief image of a pattern. The reproduction layers are applied to the support material either by the manufacturer of pre-sensitized printing plates or directly by the consumer.

The light-sensitive reproduction layers include those which are described, for example, in "Light-Sensitive Systems" by Jaromir Kosar, John Wiley & Sons, New York 1965: the layers which contain unsaturated compounds, in which these compounds are isomerized, rearranged, cyclized or crosslinked during exposure (Kosar, Chapter 4), such as, for example, cinnamates; the layers which contain photopolymerizable compounds, in which monomers or prepolymers polymerize, if appropriate by means of an initiator, during exposure (Kosar, Chapter 5); and the layers which contain o-diazoquinones, such as naphthoquinone diazides, p-diazoquinones or diazonium salt condensates (Kosar, Chapter 7).

Layers which are suitable also include the electrophotograhic layers, i.e. those which contain an inorganic or organic photoconductor. Apart from the light-sensitive substances, these layers may, of course, also contain other constituents, e.g. resins, colours, pigments, wetting agents, sensitizers, adhesion promoters, indicators, plasticizers or other customary auxiliaries.

It is also possible for semi-photoconductive layers, as described, for example, in DE-C 11 17 391, 15 22 497, 15 72 312, 23 22 046 and 23 22 047, to be applied to the support materials, resulting in highly sensitive, electrophotographic layers being formed.

The materials for printing plate supports which have been roughened using the process according to the invention have a uniform lightness and a very uniform topography, which has a beneficial effect on the print run stability and the wetting agent guiding when printing from printing formes produced from these supports. Undesirable "scars", which form noticeable indentations compared with the surrounding roughening, occur less frequently; they may even be eliminated altogether.

The process according to the invention is described in more detail below with reference to the examples and comparative examples. Important criteria cited for the quality of the surface of the support material are the treatment time, the surface roughness R_{A} of the electrochemically roughened support material, the lightness L and the print run. The shorter the treatment time for the same consumption of energy, the more quickly the support materials can pass through the installations in which they are being electrochemically roughened, so that the productivity is increased. The surface roughness R_{A} describes the surface topography with regard to evenness, freedom from scarring and surface coverage. The surface roughness is measured as standard by means of scanning electron microscopy or scanning with a roughness measurement unit. The diameter of the holes which are formed by the roughening or the base area of the elevations are determined by means of photographs which are taken, for example, with a 250, 1200 or 6000 times magnification through a scanning electron microscope with an electron beam which impinges obliquely with respect to the aluminium surface. The tilting angle is, for example, 40°. For each sample, a representative area encompassing at least 1000 holes is selected for the measurement. The diameter of each hole is measured in the plane of the surface both parallel and perpendicular to the rolling axis or strip direction of the support material. The arithmetic means of the diameters in the parallel and perpendicular direction are calculated separately, the arithmetic mean of the distribution of the hole diameters in the base structure and the arithmetic mean of the superimposed structure are determined from the elevations on the entire surface.

The surface roughness is measured in accordance with DIN standard 4768, October 1970 edition, or DIN 4762, May 1978 edition, using a roughness measuring unit over a representative measurement distance of at least 2 mm, both parallel and perpendicular to the axis. The roughness averages are separately determined and calculated from the two measurements as the arithmetic mean of the absolute distance of all points on the surface of the roughness profile from the centre line of the profile. The roughness average R_{A} is then the mean of the roughness averages in the parallel and perpendicular directions.

The aluminium used to produce the lithographic printing plates has the following topographic surface properties:
The surface has stamped-in, hemispherical indentations which have a diameter of 2 to 50 µm, the mean diameter lying in the range from 20 to 30 µm, in particular being 25 µm. The indentations are partially superimposed on one another and do no necessarily cover the entire area of the surface of the support material. The degree of surface coverage is between 50 and 100%. The surfaces of the support material which have been prestamped in this way have a surface roughness R_{A} in accordance with DIN 4762, 4768 or ISO 4287/1 of 0.30 to 1.1 µm. The aluminium support material which has been prestamped in this way is subjected to the further treatment steps as described above, including an electrochemical roughening step. Energy and/or time can be saved in this roughening step.

The columns of Table 1, containing the examples according to the invention, and of Table 2, containing comparative examples, specify the support material in column 2, the surface roughness before and after the electrochemical roughening of the prestamped support material in columns 3 and 8, the residence time and temperature in the electrolyte bath for the electrochemical roughening in columns 4 and 5, the current density and the voltage applied to the support material in columns 6 and 7, a measure of the lightness L in column 9, the layer weight after the anodic oxidation in column 10 and the print run in thousands in column 11.

In each of the cases specified in Tables 1 and 2, the support materials are also anodically oxidized, coated with a reproduction layer, exposed, developed and then printing is carried out. The specimens have an area of 9.2 dm² and are differently stamped, the designations "stamped A" and "stamped B" relating to the type of roller used during stamping.

The print run of the examples according to the invention is in all cases higher than the print run of the comparative examples. The greater the current density during roughening, the more resistant the surface layer becomes and the higher the print run which is achieved.

Apart from Example 8, the roughening times of the examples according to the invention are all less than 50 s, and, in the four examples 1, 4, 6 and 12, at 25 s they are only half the roughening times of 50 s of those comparative examples which have a conventional print run of 120,000 imprints.

It is a generally applicable statement that the roughening step is carried out in an electrolyte comprising hydrochloric acid and aluminium chloride, nitric acid and aluminium nitrate or sulphuric acid and aluminium sulphate. The surface roughness Rₐ of 0.30 to 1.1 µm of the prestamped aluminium or of the prestamped aluminium alloy changes into a surface roughness R_{A} of 1.0 to 1.5 µm as a result of the electrochemical roughening and has thus been increased by 1.3 to 3.3 times.

The temperature of the electrolyte is selected to be less than or equal to 50°C, and the residence time of the support material in the electrolyte is from 25 to 50 s, in particular from 25 to 40 s. For the Examples 1 to 4 according to the invention given in Table 1, the electrolyte contains 16 g/l of HCl and 30 g/l of aluminium chloride (AlCl₃·6H₂O). The electrolyte composition is kept constant by continuously topping up with suitably dilute acids, the electrolyte flow velocity at the surface of the support material being from 5 to 100 cm/s.

At a temperature of 40°C, a current density of 35 to 40 A/dm² and a residence time of the support material of 25 to 30 s, the support material is roughened to a surface roughness R_{A} of 1.0 to 1.08 µm. If the current density is reduced, specifically to a value in the range from 30 to 34 A/dm², for a residence time of the support material in the electrolyte of 40 s and a temperature of 40°C, the resulting surface roughness R_{A} is from 1.20 to 1.24 µm. At a temperature of the electrolyte of 40°C and a current density of 35 A/dm² and a residence time of 30 s, the surface roughness R_{A} is 1.12 to 1.15 µm.

It is found that, if the surface roughness Rₐ of the prestamped support material is higher, the surface roughness R_{A} achieved after roughening is likewise higher. For example, if the surface roughness Rₐ of the prestamped support material is 0.90 µm, the surface roughness R_{A} of the roughened support material is 1.40 to 1.44 µm, at an electrolyte temperature of 40°C, a current density of 40 A/dm² and a residence time of the support material in the electrolyte of 25 s.

Starting from a surface roughness Rₐ of 0.90 of the prestamped support material, a surface roughness R_{A} of 1.30 to 1.34 µm is achieved at an electrolyte temperature of 40°C, a current density of 30 A/dm² and a residence time of the support material in the electrolyte of 30 s.

A suitable electrolyte for anodization contains, for example, 50 g/l of nitric acid and 8 g/l of aluminium nitrate [Al(NO₃)₂·9H₂O].

Alternating voltages with a power supply frequency of 50 Hz or superimposed alternating voltages with a frequency of less than 50 Hz are used for the roughening. The current density of the alternating current is in particular 30 to 45 A/dm², but may also be 25 or 50 A/dm².

After the electrochemical roughening, an anodizing step takes place in an electrolyte which contains sulphuric acid, phosphoric acid, oxalic acid, amidosulphonic acid, sulphosuccinic acid, sulphosalicylic acid or mixtures of these acids. The anodic oxidation in the anodizing step takes place by means of direct current, alternating current or direct current with superimposed alternating current, and the layer weights of the aluminium oxide which are achieved are 1 to 3 g/m².

After the anodic oxidation, the light-sensitive reproduction layer is applied which has, for example, the composition described above. The drying of this composition on the support material takes place at temperatures of up at most 120°C.

A further electrolyte for the anodizing consists, for example, of 100 g/l of sulphuric acid and 65 g/l of aluminium sulphate.

The examples according to the invention given in Table 1 provide printing plates with good copying and printing properties with regard to correctability, developability, resolution, water carrying and the like, and print runs of 140 thousand and in particular of more than 150 thousand imprints are achieved.

The same electrolyte as for Inventive Examples 1 to 4 was used for the roughening in the comparative examples given in Table 2, in particular Comparative Examples V1 and V2. The Comparative Example V3 was roughened in the same electrolyte as the Inventive Example 5. The Comparative Examples V4, V5 and V6 were anodized in a sulphuric acid electrolyte comprising 100 g/l of sulphuric acid and 65 g/l of aluminium sulphate using direct current without a prior roughening step.

The Comparative Example V1 was anodized and coated in the customary way after roughening. The printing plate obtained had standard copying properties with regard to dot gain, water carrying, print run and the like and behaved in the same way as a commercially available printing plate. The same results were achieved with Comparative Examples V2, V3 and V11. Wet-brushed support material was used for Comparative Example V2, with the result that residual structures from the brushing operation were retained, making the water carrying of the printing plate orientation-dependent, so that this printing plate was not universally usable.

The remaining Comparative Examples V4 to V10 in each case only achieved a very low print run of at most 25 thousand imprints.

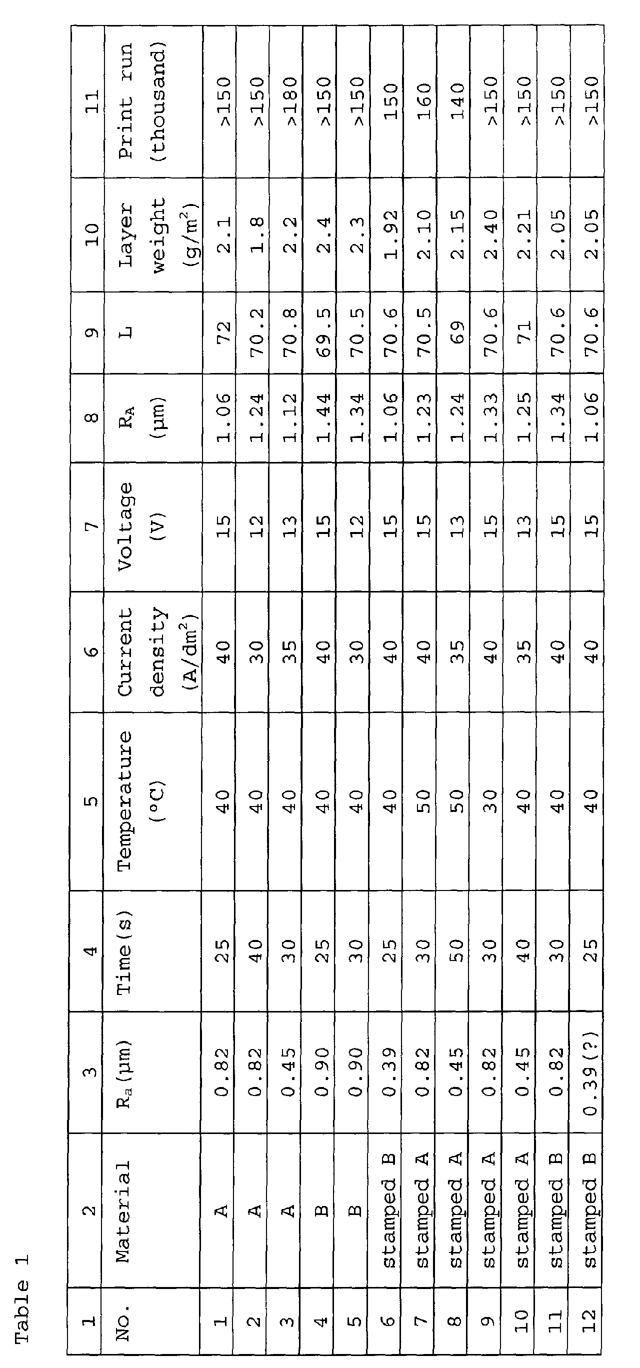

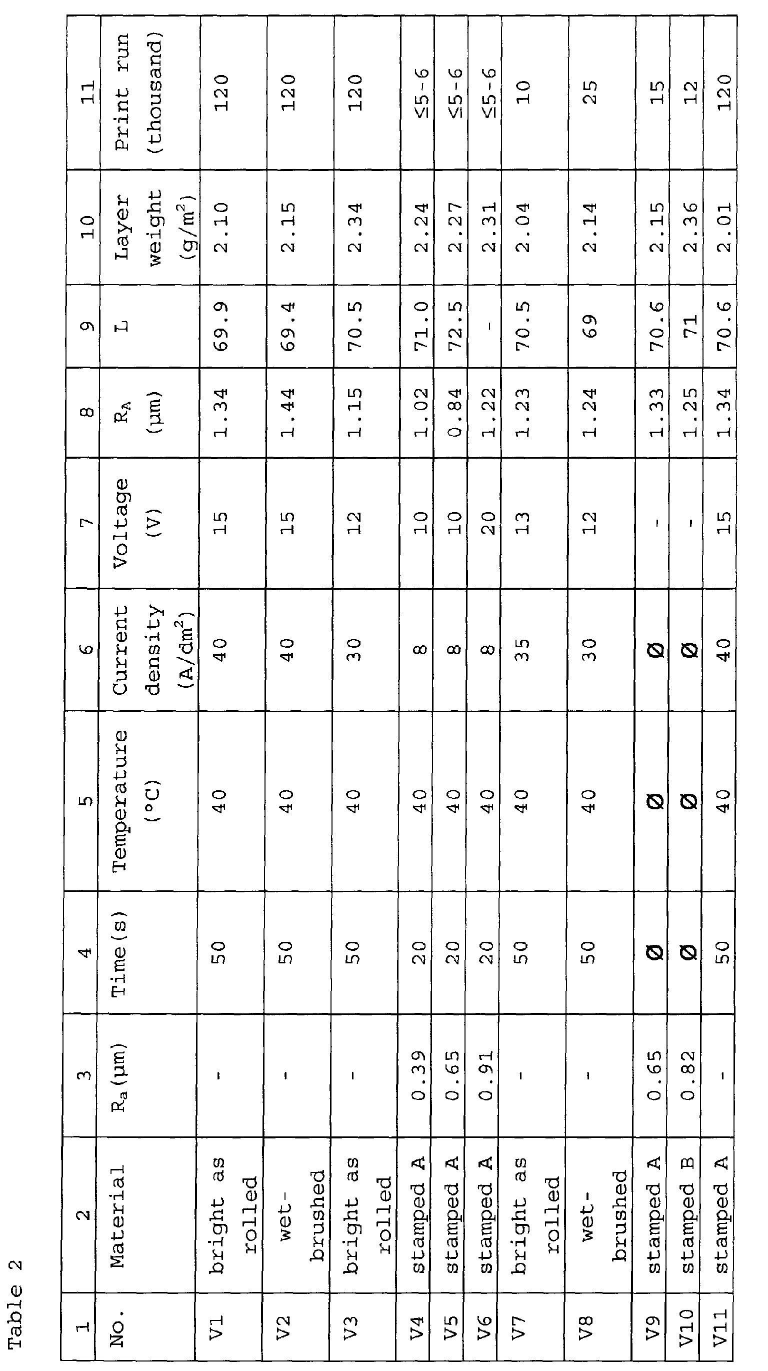

## Claims

1. Process for roughening support material for printing plates made from prestamped aluminium or prestamped aluminium alloys, in one surface of which hemispherical indentations with a diameter of from 2 to 50 µm are stamped, in which an electrochemical roughening step is carried out in such a manner that
- the electrochemical roughening step proceeds by means of alternating current in an electrolyte which is selected from the group consisting of hydrochloric acid, nitric acid, sulphuric acid and chloride or nitrate ions of an aluminium salt, and in such a manner that
- roughening is carried out uniformly and in an area-covering manner, with a surface roughness R_{A} of from 1.0 to 1.5 µm.

2. Process according to Claim 1, **characterized in that** the roughening step is carried out in an electrolyte comprising hydrochloric acid and aluminium chloride, nitric acid and aluminium nitrate or sulphuric acid and aluminium sulphate, the surface roughness Rₐ of from 0.30 to 1.1 µm of the prestamped aluminium or the prestamped aluminium alloy being increased by 1.3 to 3.3 times.

3. Process according to Claim 2, **characterized in that** the temperature of the electrolyte is selected to be less than or equal to 50°C, for a residence time of the support material in the electrolyte of from 25 to 50 s.

4. Process according to Claim 2, **characterized in that** the electrolyte composition is kept constant by continuously topping up with suitably dilute acids, and **in that** the electrolyte flow velocity at the surface of the support material is from 5 to 100 cm/s.

5. Process according to Claim 1, **characterized in that** the current density of the alternating current is 30 to 45 A/dm².

6. Process according to Claim 2, **characterized in that** the roughening step takes place in an electrolyte which contains 16 g/l of HCl and 30 g/l of aluminium chloride (AlCl₃·6H₂O), at a temperature of 40°C, a current density of 35-40 A/dm² and a residence time of the support material of 25-30 s.

7. Process according to Claim 6, **characterized in that** the support material is roughened to a surface roughness R_{A} of 1.0 to 1.08 µm.

8. Process according to Claim 2, **characterized in that** the roughening step takes place in an electrolyte which contains 16 g/l of HCl and 30 g/l of aluminium chloride (AlCl₃·6H₂O), at a temperature of 40°C, a current density of 30-34 A/dm² and a residence time of the support material of 40 s.

9. Process according to Claim 8, **characterized in that** the support material is roughened to a surface roughness R_{A} of 1.20 to 1.24 µm.

10. Process according to Claim 2, **characterized in that** the roughening step takes place in an electrolyte which contains 16 g/l of HCl and 30 g/l of aluminium chloride (AlCl₃·6H₂O), at a temperature of 40°C, a current density of 35 A/dm² and a residence time of the support material of 30 s.

11. Process according to Claim 8, **characterized in that** the support material is roughened to a surface roughness R_{A} of 1.12 to 1.15 µm.

12. Process according to Claim 2, **characterized in that** the roughening step takes place in an electrolyte which contains 16 g/l of HCl and 30 g/l of aluminium chloride (AlCl₃·6H₂O), at a temperature of 40°C, a current density of 40 A/dm² and a residence time of the support material of 25 s.

13. Process according to Claim 12, **characterized in that** the support material is roughened to a surface roughness R_{A} of 1.40 to 1.44 µm.

14. Process according to Claim 2, **characterized in that** the roughening step takes place in an electrolyte which contains 50 g/l of nitric acid and 8 g/l of aluminium nitrate [Al(NO₃)₂·9H₂O], at a temperature of 40°C, a current density of 30 A/dm² and a residence time of the support material of 30 s.

15. Process according to Claim 14, **characterized in that** the support material is roughened to a surface roughness R_{A} of 1.30 to 1.34 µm.

16. Process according to Claims 1 to 15, **characterized in that** the roughening step takes place using alternating voltages with a power frequency of 50 Hz or with superimposed alternating voltages with a frequency of less than 50 Hz.

17. Process according to one of Claims 1 to 6, **characterized in that** an anodizing step takes place in an electrolyte which contains sulphuric acid, phosphoric acid, oxalic acid, amidosulphonic acid, sulphosuccinic acid, sulphosalicylic or mixtures of these acids.

18. Process according to Claims 1 to 17, **characterized in that** the anodic oxidation takes place using direct current, alternating current or direct current with superimposed alternating current, and **in that** layer weights of 1 to 3 g/m² of aluminium oxide are obtained.

19. Printing plate made from a support material, produced according to one or more of Claims 1 to 18, **characterized in that** the support material is coated with a radiation-sensitive layer of the following composition (pbw = parts by weight, pbv = parts by volume):
| | |
|---|---|
| 6.6 pbw | of cresol/formaldehyde novolak with a softening range of 105 to 120°C, |
| 1.1 pbw | of the 4-(2-phenyl-2-propyl)-phenyl ester of 1,2-naphthoquinone-2-diazide-4-sulphonic acid, |
| 0.6 pbw | of 2,2'-bis(1,2-naphthoquinone-2-diazide-5-sulphonyloxy)-1,1'-dinaphthylmethane, |
| 0.24 pbw | of 1,2-naphthoquinone-2-diazide 4-sulphochloride, |
| 0.08 pbw | of Crystal Violet |
| 91.36 pbw | of a solvent mixture comprising 4 pbv ethylene glycol monomethyl ether, 5 pbv tetrahydrofuran and 1 pbv butyl acetate. |

20. Printing plate according to Claim 19, **characterized in that** the drying of the coated support material takes place at temperatures of up to 120°C.
